Europäisches Patentamt

European Patent Office

Office européen des brevets

(19)

(11) Veröffentlichungsnummer: **0 296 385**
**A2**

## EUROPÄISCHE PATENTANMELDUNG

(21) Anmeldenummer: 88108721.7

(22) Anmeldetag: 31.05.88

(51) Int. Cl.4 **H01J 37/067**

(30) Priorität: 26.06.87 DE 3721177

(43) Veröffentlichungstag der Anmeldung:
**28.12.88 Patentblatt 88/52**

(84) Benannte Vertragsstaaten:
**DE FR GB NL**

(71) Anmelder: **Siemens Aktiengesellschaft Berlin und München**
**Wittelsbacherplatz 2**
**D-8000 München 2(DE)**

(72) Erfinder: **Frosien, Jürgen, Dr. Ing.**
**An der Ottosäule 18**
**D-8012 Ottobrunn(DE)**
Erfinder: **Sturm, Matthias, Dipl.-Ing.**
**Hauptstrasse 11a**
**D-8014 Neubiberg(DE)**

(54) Strahlerzeugendes System für Korpuskularstrahlgeräte.

(57) Ein wesentliches Kriterium für die Beurteilung der Leistungsfähigkeit eines Korpuskularstrahlgerätes ist der auf der Probe zur Verfügung stehende Sondenstrom i, der über die Gleichung $i = \text{Konst.} \; \alpha^2 d^2 R$ von der Endapertur $\alpha$, dem Sondendurchmesser d und dem Richtstrahlwert R der Teilchenquelle abhängt. Den maximalen Richtstrahlwert der Quelle kann man allerdings nur dann ausnutzen, wenn diese auf der optischen Achse des Korpuskularstrahlgerätes angeordnet ist. Mit den üblicherweise als Teilchenquellen eingesetzten Triodensystemen läßt sich dieser Idealzustand nur näherungsweise verwirklichen, da die Kathode im allgemeinen nicht auf der durch die Wehnelt-Elektrode und die Anode definierten Achse angeordnet werden kann. Es wird deshalb vorgeschlagen, die Kathode drehbar im Gehäuse des strahlerzeugenden Systems anzuordnen. Die Drehachse liegt hierbei vorzugsweise in einer annähernd senkrecht zur optischen Achse des Korpuskularstrahlgerätes orientierten Ebene oberhalb der Quelle.

FIG 1

## Strahlerzeugendes System für Korpuskularstrahlgeräte

Die Erfindung betrifft ein strahlerzeugendes System für Korpuskularstrahlgeräte nach dem Oberbegriff des Patentanspruchs 1.

Ein wesentliches Kriterium für die Beurteilung der Leistungsfähigkeit eines Korpuskularstrahlgerätes ist der auf der Probe zur Verfügung stehende Sondenstrom i. der über die Gleichung

$$ i = \left(\frac{\pi}{2}\right)^2 \alpha^2 \cdot d^2 \cdot R $$

von der Endapertur $\alpha$ der Objektivlinse, dem Sondendurchmesser d und dem Richtstrahlwert R der Teilchenquelle abhängt. Für meßtechnische Untersuchungen werden deshalb Quellen mit hohem Richtstrahlwert eingesetzt. Den maximalen Richtstrahlwert der Quelle kann man allerdings nur dann ausnutzen, wenn diese auf der optischen Achse des Korpuskularstrahlgerätes angeordnet ist. Mit den üblicherweise als Teilchenquellen eingesetzten Triodensystemen läßt sich dieser Idealzustand nur näherungsweise verwirklichen, da die Kathode aufgrund mechanischer Toleranzen bei deren Fertigung und deren Einbau in das Korpuskularstrahlgerät im allgemeinen nicht exakt auf der durch die Wehnelt-Elektrode und die Anode definierten Achse zentriert angeordnet werden kann. Außerdem ist es im allgemeinen nur sehr schwer möglich, die beim Aufheizen der Kathode auftretenden Drifteffekte zu kompensieren. Konventionelle Transmissions- und Rasterelektronenmikroskope werden deshalb mit mechanischen oder elektronenoptischen Vorrichtungen zur Korrektur der Dezentrierung der Quelle ausgestattet.

Es ist bekannt Dezentrierungen der Kathode mit Hilfe elektromagnetischer Ablenksysteme zu korrigieren (z. B. Rasterelektronenmikroskop 525 der Firma Philips). Es ist weiterhin bekannt, eine Dezentrierung von Kathode und Wehnelt-Elektrode durch eine gegenwirkende Dezentrierung von Anode und Wehnelt-Elektrode Kathode auszugleichen (Amray Rasterelektronenmikroskop 1610). Diese Korrektureinrichtungen arbeiten zufriedenstellend, besitzen allerdings eine Reihe von Nachteilen:

Elektromagnetische Ablenksysteme kann man nur dann zur Korrektur der Dezentrierung der Kathode verwenden, wenn zwischen der Quelle und dem Ablenksystem keine die Strahlcharakteristik einschränkenden Blenden vorhanden sind. Darüberhinaus wird der Richtstrahlwert der Quelle durch die Aberrationen des Ablenksystems verschlechtert.

Die mechanische Verschiebung der Einheit Kathode Wehnelt-Elektrode relativ zur Anode ist elektronenoptisch von Nachteil. Außerdem ist die Korrektur von den an den Elektroden anliegenden Potentialen abhängig, so daß nach jeder Änderung der Strahlenergie oder des Emissionsstromes neu abgeglichen werden muß.

Wünschenswert sind deshalb Einrichtungen, die die Ursache der Dezentrierung der Quelle während des Betriebes beseitigen.

Der Erfindung liegt die Aufgabe zugrunde, ein strahlerzeugendes System der eingangs genannten Art anzugeben, das eine mechanisch einfache Zentrierung der Elektroden auf der optischen Achse des Korpuskularstrahlgeräts gewährleistet. Diese Aufgabe wird erfindungsgemäß durch ein strahlerzeugendes System nach Patentanspruch 1 gelöst.

Der mit der Erfindung erzielbare Vorteil besteht insbesondere darin, daß Zentrierfehler der Kathode während des Betriebes beseitigt werden können.

Die Ansprüche 2 bis 9 sind auf bevorzugte Ausgestaltungen und Weiterbildungen der im folgenden anhand der Zeichnungen näher erläuterten Erfindung gerichtet.

Hierbei zeigt:

FIG 1 den prinzipiellen Aufbau eines erfindungsgemäßen Strahlerzeugers für ein Elektronenstrahlmeßgerät,

FIG 2 bis 4 erfindungsgemäße Vorrichtungen zur Zentrierung der Kathode auf der optischen Achse des Elektronenstrahlmeßgerätes.

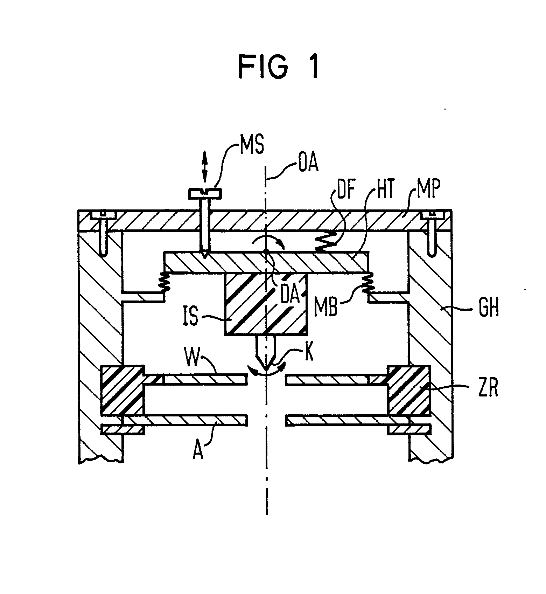

Der in FIG 1 schematisch dargestellte Strahlerzeuger für ein Elektronenstrahlmeßgerät, insbesondere ein Rasterelektronenmikroskop oder ein Elektronenstrahltester, besteht im wesentlichen aus einer auf einem zylinderförmigen Isolator IS angeordneten Kathode K, einer mit einem negativen Potential von beispielsweise 0.5 - 1.5 kV (bezogen auf das Potential der Kathode) beaufschlagten Steuerelektrode W (Wehnelt-Elektrode), einer üblicherweise auf Erdpotential liegenden Anode A, die fest in das Gehäuse GH des Strahlerzeugers eingebaut und mittels Zentrierringen ZR relativ zur ebenfalls starr mit dem Gehäuse GH verbunden Steuerelektrode W ausgerichtet ist, und einer Kippeinrichtung zur Drehung der auf einem hohen Potential von beispielsweise - 10 kV (bezogen auf das Potential der Anode) liegenden Kathode K um eine oberhalb der Kathodenhalterung liegende Achse DA. Die Kippeinrichtung umfaßt eine starr mit dem Gehäuse GH verbundene Metallplatte MP und einen den Isolator IS und die Kathode K tragenden Halterungsteil HT, der über einen elastischen Metallbalg MB vakuumdicht mit dem Gehäuse GH verbunden ist und mit Hilfe der außerhalb der durch die zentrierte Einheit aus Steuerelektrode W und Anode A definierten Symmetrieachse OA angreifenden Stellschraube MS um die Achse DA gekippt werden kann. Um sicherzustellen, daß der Halterungsteil HT unabhängig von dessen Neigungsgrad immer an der in einer Bohrung der Metallplatte MP geführten Stellschraube MS anliegt, ist eine die erforderliche Rückstellkraft erzeugende Druckfeder DF vorgesehen, die man vorzugsweise symmetrisch zur Stellschraube MS zwischen der Metallplatte MP und dem Halterungsteil HT anordnet. Eine Dezentierung der eingebauten und auf die erforderliche Betriebstemperatur aufgeheizten Kathode K kann somit sehr einfach durch eine Drehung der beweglichen Teile des Strahlerzeugers erreicht werden, wobei die Drehachse DA vorzugsweise in einer annähernd senkrecht zur optischen Achse OA orientierten Ebene oberhalb der Kathode K liegt. Die mit der Drehbewegung verbundene Änderung des Abstandes zwischen Kathode K und Steuerelektrode W kann durch eine geeignete Dimensionierung des Abstandes zwischen Drehachse DA und Kathode K vernachlässigbar klein gehalten werden. Da die Kathode K vor der Messung mit Hilfe der mechanischen Kippeinrichtung exakt auf der optischen Achse OA des Systems zentriert wird, entfällt die in konventionellen Anordnungen notwendige Neujustierung bei Änderungen der Strahlenergie oder des Emissionsstromes. Außerdem werden thermische Drifterscheinungen vollständig unterdrückt, da man die Kathode K im aufgeheizten Zustand zentriert.

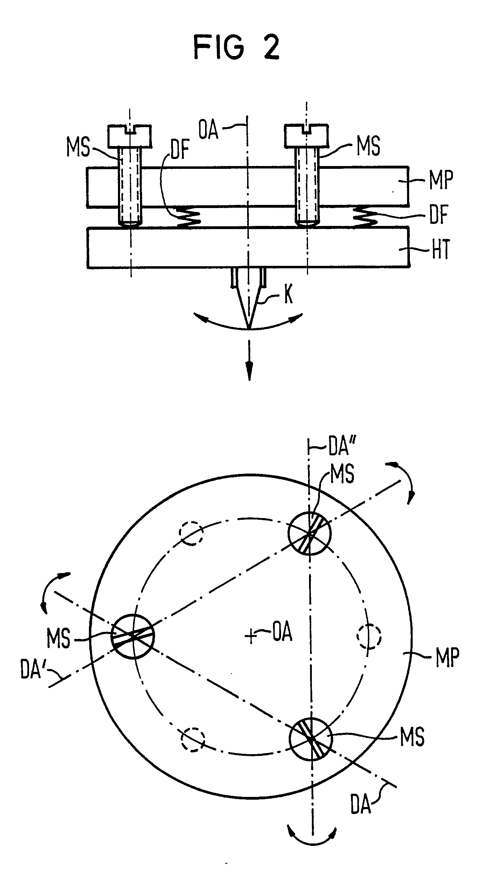

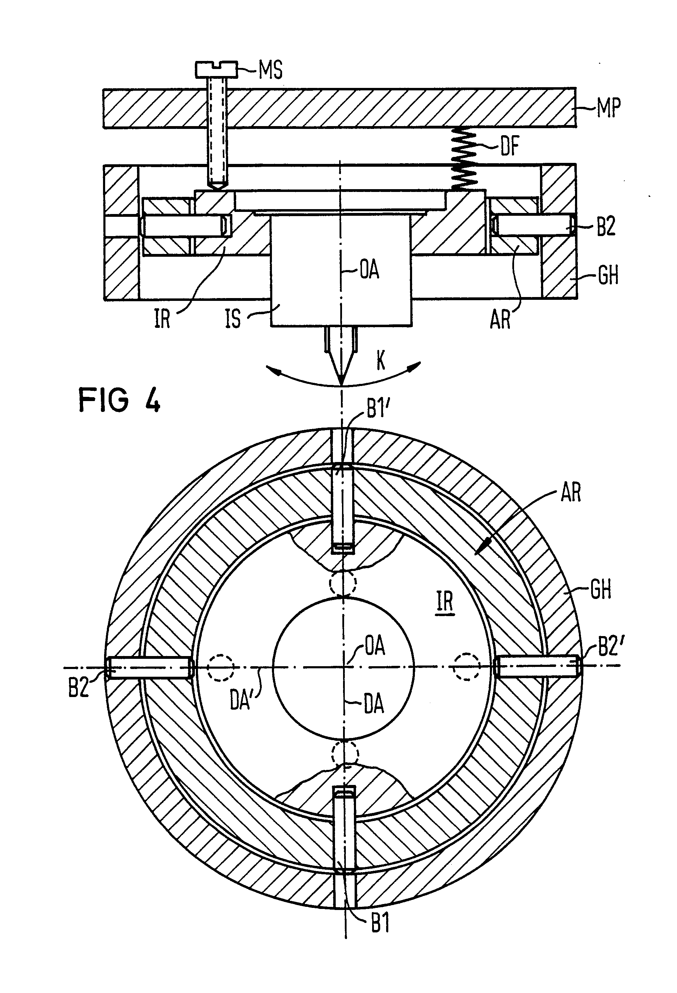

Ausführungsbeispiele erfindungsgemäßer Kippeinrichtungen zur Zentrierung der Kathode K auf der optischen Achse des Elektronenstrahlmeßgerätes werden im folgenden anhand der FIG 2 bis, FIG 4 erläutert. Aus Gründen der Übersichtlichkeit sind jeweils nur die die Drehbewegung der Kathode bewirkenden Teile des Strahlerzeugers schematisch dargestellt.

Mit der Kippeinrichtung nach FIG 2 kann man die Lage der Kathode K in der Bohrung der Steuerelektrode W mit drei außerhalb der Symmetrieachse OA des Halterungsteils HT angreifenden Stellschrauben MS (beispielsweise Mikrometerschrauben mit oder ohne Untersetzung) verändern. Diese Stellschrauben MS sind hierbei vorzugsweise derart auf einem konzentrisch zur Symmetrieachse OA der Metallplatte MP liegenden Kreis angeordnet, daß die die Mittelpunkte der Bohrungen verbindenden Geraden ein gleichseitiges Dreieck einschließen. Infolge dieser Anordnung der Stellschrauben MS und der den Stellschrauben MS jeweils zugeordneten Druckfedern DF, kann die Kathode K um drei in der Ebene des Halterungsteils HT liegende Achsen gekippt werden, wobei die Drehachsen mit den die Auflagepunkte der Stellschrauben MS verbindenden Geraden DA, DA', DA" zusammenfallen. Außerdem ist eine Verschiebung der Kathode K in Richtung der optischen Achse OA durch eine gleichförmige Bewegung aller Stellschrauben MS gewährleistet.

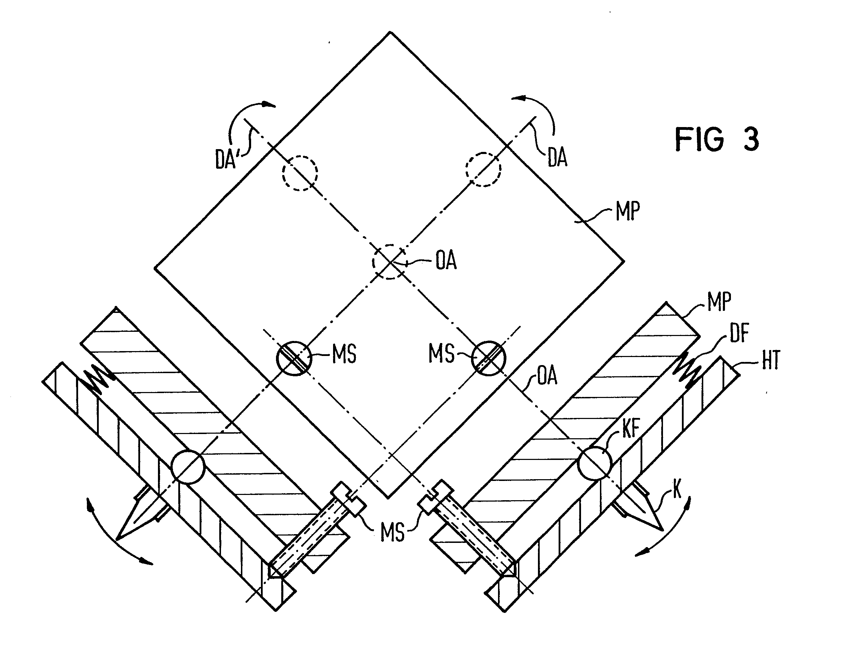

Die in FIG 3 dargestellte Kippeinrichtung besteht aus einer fest mit dem Gehäuse GH verbundenen Metallplatte MP, einem die Kathode K tragenden Halterungsteil HT und einer zwischen der Metallplatte MP und dem Halterungsteil HT auf der Symmetrieachse OA des Systems angeordneten Kugelführung KF. Die durch den Auflagepunkt der Kugelführung KF und die Angriffspunkte der Stellschrauben MS bzw. Druckfedern DF definierten Drehachsen DA bzw. DA' erlauben eine Verschiebung der Kathode K in zwei zueinander orthogonale Richtungen.

Eine Kippeinrichtung mit einer kardanisch aufgehängten Kathode K ist schematisch in FIG 4 dargestellt. Wie der untere Teil der Abbildung zeigt, besteht der Halterungsteil HT aus zwei konzentrisch zur Symmetrieachse OA des Systems angeordneten ringförmigen Teilen IR bzw. AR, wobei der die Kathode K und den Isolator IS tragende innere Ring IR um die durch das Bolzenpaar B1, B1' definierte Achse DA und der äußere Ring AR unabhängig von der Bewegung des inneren Teils um die durch das Bolzenpaar B2 bzw. B2' definierte Achse DA' gedreht werden kann. Die Drehbewegung um eine dieser Achsen DA bzw. DA' wird wieder durch jeweils eine außerhalb der Symmetrieachse OA, vorzugsweise auf der Verbindungslinie der Bolzenpaare B1, B1' bzw. B2, B2' angreifende Stellschraube MS und der der Stellschraube MS jeweils zugeordneten Druckfeder DF bewirkt (die Auflagefläche der Stellschrauben bzw. der Druckfedern ist durch offene Kreise angedeutet).

## Ansprüche

1) Strahlerzeugendes System für Korpsukularstrahlgeräte mit einer teilchenemittierenden Quelle (K), einer Steuerelektrode (W) und einer teilchenbeschleunigenden Elektrode (A), dadurch **gekennzeichnet,** daß die Steuerelektrode (W) und die teilchenbeschleunigende Elektrode (A) eine zentrierte Einheit bilden und daß die Quelle (A) um mindestens eine außerhalb der Quelle liegende Achse (DA) drehbar im Gehäuse des strahlerzeugenden Systems angeordnet ist.

2) Strahlerzeugendes System nach Anspruch 1, dadurch **gekennzeichnet,** daß die Achse (DA) oberhalb der Quelle (K) liegt.

3) Strahlerzeugendes System nach Anspruch 1 oder 2, dadurch **gekennzeichnet,** daß die Achse (DA) in einer annähernd senkrecht zur Symmetrieachse (OA) des strahlerzeugenden Systems orientierten Ebene liegt.

4) Strahlerzeugendes System nach einem der Ansprüche 1 bis 3, dadurch **gekennzeichnet, daß** die Quelle (K) kardanisch aufgehängt ist.

5) Strahlerzeugendes System nach einem der Ansprüche 1 bis 4, **gekennzeichnet** durch einen mit dem Gehäuse (GH) des strahlerzeugenden Systems starr verbundenen ersten Halterungsteil (MP), einen die Quelle (K) tragenden und gegenüber dem ersten Halterungsteil (MP) beweglichen zweiten Halterungsteil (HT) und eine Einrichtung (MS) zur Änderung des Neigungswinkels des zweiten Halterungsteils (HT) bezüglich des ersten Halterungsteils (MP).

6) Strahlerzeugendes System nach Anspruch 5, dadurch **gekennzeichnet, daß** die Einrichtung zur Änderung des Neigungswinkels aus mindestens einer außerhalb der Symmetrieachse (OA) des zweiten Halterungsteils (HT) angreifenden Stellschraube (MS) und einem der Stellschraube zugeordneten Federelement (DF) besteht.

7) Strahlerzeugendes System nach Anspruch 5, **gekennzeichnet** durch ein zwischen dem ersten und dem zweiten Halterungsteil (MP, HT) auf der Symmetrieachse (OA) des strahlerzeugenden Systems angeordnete Kugelführung (KF).

8) Strahlerzeugendes System nach Anspruch 5, dadurch **gekennzeichnet, daß** der zweite Halterungsteil (HT) über einen elastischen Metallbalg (MB) vakuumdicht mit dem Gehäuse (GH) verbunden ist.

9) Strahlerzeugendes System nach Anspruch 5, dadurch **gekennzeichnet, daß** der zweite Halterungsteil (HT) zwei konzentrisch angeordnete ringförmige Teile (IR, AR) aufweist, wobei der die Quelle (K) tragende innere Teil (IR) um eine erste Achse (DA') und der äußere Teil (AR) um eine zweite Achse (DA') drehbar gelagert ist.

# FIG 1

# FIG 2

FIG 3

FIG 4